Europäisches Patentamt

European Patent Office

Office européen des brevets

(19)

(11) **EP 0 981 055 B1**

(12) **EUROPEAN PATENT SPECIFICATION**

(45) Date of publication and mention
of the grant of the patent:
**02.10.2002 Bulletin 2002/40**

(51) Int Cl.⁷: **G01S 13/89**, G01R 23/163

(21) Application number: **99203841.4**

(22) Date of filing: **12.01.1995**

(54) **Non-contact type wave signal observation apparatus**

Berührungslose-Beobachtungsvorrichtung von Wellensignalen

Appareil d'observation d'un signal sans contact

(84) Designated Contracting States:
**DE FR GB NL SE**

(30) Priority: **12.01.1994 JP 157494**
**12.01.1994 JP 157594**
**13.01.1994 JP 190494**
**19.01.1994 JP 410794**
**21.01.1994 JP 540294**

(43) Date of publication of application:
**23.02.2000 Bulletin 2000/08**

(62) Document number(s) of the earlier application(s) in
accordance with Art. 76 EPC:
**95400057.6 / 0 667 538**

(73) Proprietor: **Advantest Corporation**
**Nerima-ku, Tokyo 179-0071 (JP)**

(72) Inventor: **Kitayoshi, Hitoshi**
**Tokyo (JP)**

(74) Representative: **Joly, Jean-Jacques et al**
**Cabinet Beau de Loménie**
**158, rue de l'Université**
**75340 Paris Cédex 07 (FR)**

(56) References cited:
**US-A- 4 309 602**     **US-A- 4 561 019**

**Description**

FIELD OF THE INVENTION

The invention relates to non-contact type wave signal observation apparatus. More particularly, the invention relates to an apparatus which measures, in a non-contact manner, spectra and waveforms of signals on distributed constant networks mainly used in the microwave and millimeter wave region and which contain internal signal sources.

BACKGROUND OF THE INVENTION

To aid understanding of the present invention, there shall be described wave signal observation apparatus which measures, in a non-contact manner, transfer functions of distributed constant networks which do not include internal signal sources. Problems affecting conventional apparatus of that type shall now be described.

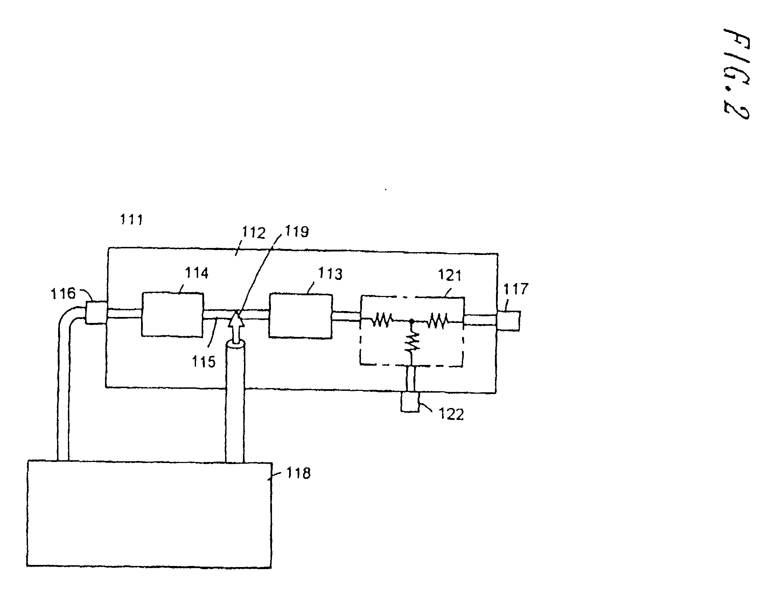

Fig.2 illustrates a conventional transfer function measurement apparatus, this apparatus being a contact-type measurement apparatus. A distributed constant network 111 under observation is composed of a substrate 112 bearing a passive element 113 and an active element 114 connected by a distributed constant line 115 such as a microstrip line. Input terminal 116 and output terminal 117, which respectively input and output signals, are provided in the network 111.

In the conventional transfer function measurement apparatus, the transfer function between the input terminal 116 and the output terminal 117 is measured, as follows. A test signal is input from the network analyzer 118 to the input terminal 116. The corresponding signal output from the output terminal 117 is input to the network analyzer and the transfer function is calculated.

In the conventional transfer function measurement apparatus, the transfer function at a location between the input and output terminals is measured as follows. A test signal is input from the network analyzer 118 to the input terminal 116. A contact type probe 119 is placed in contact with the location between the input and output terminals of the network 111 where it is desired to measure the transfer function, and a signal is taken out at that location. The extracted signal is input to the network analyzer 118 and the transfer function is calculated.

When it is known beforehand that it will be necessary to measure the transfer function at a particular location between the input and output terminals of the network 111, a power splitter 121 is connected at that particular location. The network 111 is provided beforehand with a test terminal 122 connected to the power splitter 121 and signals are input and output through test terminal 122. A test signal is passed between the input terminal 116 and the test terminal 122 and/or between the test terminal 122 and the output terminal 117 and the corresponding output signal is extracted for calculation of the transfer function.

The contact type probe 119 influences the circuit parameters which it is measuring. Thus, it is impossible to obtain an accurate measurement when a contact-type probe is used to access a location between the input and output terminals of the network 111. Moreover, when test terminal 122 is used there is a comparatively large loss of signal level because of the presence of power splitter 121 in the network. Furthermore, power splitter 121 may be integrated into a unit with other circuit elements of the network 111. In such a case it becomes difficult to manufacture a network which performs a desired operation correctly.

Now, prior art will be described which relates to the present invention. It will be recalled that the present invention relates to non-contact type wave signal observation apparatus which measures the spectrum and waveform of signals of a distributed constant network having internal signal sources.

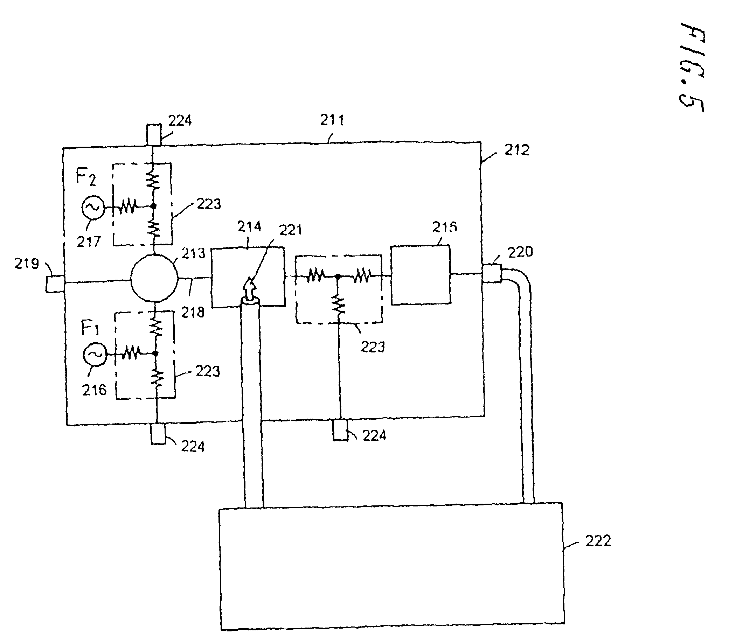

Fig.5 shows a prior art signal observation apparatus in which a distributed constant network 211 under observation comprises oscillators 216, 217, a passive element 213, an active element 215 and a distributed constant line 218. Input terminal 219 and output terminal 220 are also provided. A contact type probe 221 is placed in contact with a location in the network 211 at which it is desired to make an observation. The signal detected at that location by the contact type probe 221 is input to a measurement unit 222, such as an oscilloscope, which detects the signal waveform at the observation point. Alternatively, the signal output at the output terminal 220 is fed to the measurement unit 222.

As shown in Fig.5, a power splitter 223 is connected at a point in the network where it is known beforehand that it will be desired to take a measurement, and an associated test terminal 224 is also provided. A signal output at this test terminal 224 may be input to the measurement unit 222.

When measurements are made at locations in the network other than terminals the contact probe 221 influences the measurement, by virtue of the fact that it makes contact with the network, and renders it impossible to obtain an accurate measurement of the characteristics of the network 211.

On the other hand, there are constant, comparatively-large signal losses when a power splitter 223 and test terminal 224 are provided in the network 211. Also, the ability to make a measurement at a given location in the network depends upon whether or not a test terminal has been provided at that location beforehand.

## SUMMARY OF THE INVENTION

The present invention provides a non-contact type wave signal observation apparatus in which an electromagnetic wave observation plane is set up in relation to a distributed constant network under observation and electromagnetic waves received at each observation point on the observation plane give rise to output voltage signals. Signals are given out by the distributed constant network in a repetitive fashion. The repeating signal is detected and a reference pulse signal synchronised with it is generated. The obtained voltage for each observation point at each of a plurality of observation frequencies is converted to a complex voltage based upon the phase of the reference pulse signal and the result is memorized in data memories. Hologram reconstruction calculations, such as an inverse-Fresnel transform or a Fourier transform, are performed on the complex voltage values stored in the data memories and the results are memorized in image memories. The data memorized in the image memories is displayed as spectra or as signal waveforms.

Preferably, the data read from the image memories is corrected before display so as to compensate for radiation frequency characteristics of the observing device (e.g. antenna and associated circuitry). Also, it is preferred that the conversion of each measured voltage to a complex voltage be performed, as follows: a frequency component corresponding to the observation frequency is extracted from the measured voltage and from the reference pulse signal, these extracted signals are each low pass filtered and subjected to a discrete Fourier transform, then the transformed signal derived from the measured voltage is converted dependent upon the phase of the transformed signal derived from the pulse signal.

## BRIEF DESCRIPTION OF THE DRAWINGS

Fis.1 is a block diagram showing non-contact type transfer function measurement apparatus helpful to aid understanding of the invention.

Fig.2 is a block diagram showing a transfer function measurement apparatus predating that of Fig.1.

Fig.3 is a block diagram showing an embodiment of a non-contact type wave signal observation apparatus according to the present invention.

Fig.4 is a block diagram showing an alternative implementation of a component of the apparatus of Fig.3.

Fig.5 is a block diagram showing a prior art wave signal observation apparatus.

Fig.6 is a block diagram showing an embodiment of a complex wave interference information display apparatus which may be used to display data obtained by the non-contact type wave signal observation apparatus according to the invention.

Fig.7 shows an example of results displayed using the apparatus of Fig.6.

## DESCRIPTION OF THE PREFERRED EMBODIMENTS

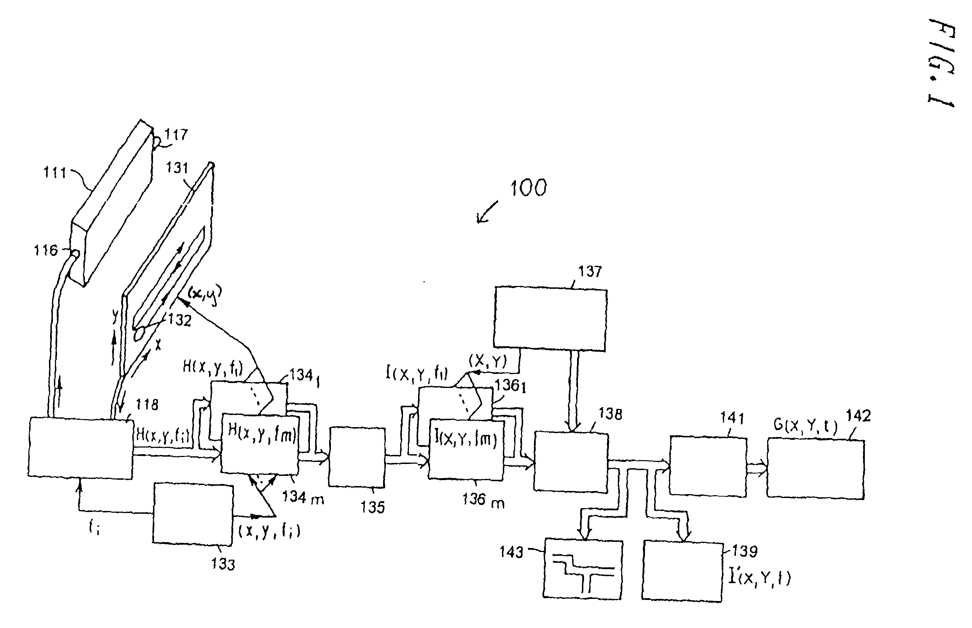

Before describing the apparatus according to the present invention, a non-contact type transfer function measurement apparatus is explained below referring to Fig.1.

An observation plane 131 is set up in the vicinity of a distributed constant network 111 which is to be observed. The distributed constant network 111 has an input terminal 116 and an output terminal 117. A signal is input to the input terminal 116 of the distributed constant network 111 and the transfer function measuring means 100 measures the transfer function $H(x,y,f_i)$ between the input terminal 116 of the distributed constant network 111 and each observation point $(x,y)$ on the observation plane 131 at an observation frequency $f_i$. The input signal may be provided by a network analyzer 118 of the transfer function measuring means 100.

Scanning-antenna receiving means is installed in the receiving plane 131. For instance, an antenna 132 may be provided in the observation plane 131 so as to receive electromagnetic waves radiated from the distributed constant network 111. In this case, the antenna 132 is successively moved from one observation point $(x,y)$ to the next so as to successively output to the network analyzer 118 voltages indicative of the electromagnetic waves received at each respective observation point on the observation plane. Alternatively, an array of individual antennas can be used, antennas of the array being positioned to correspond to the observation points $(x,y)$ of the observation plane, and each element of the array can successively output its received signal to the network analyzer 118. One example of a scanning-antenna receiving means suitable for use in the present apparatus, and in embodiments of the invention described below, is disclosed in "Near-Field Antenna Measurements" by Dan Slater (Artech House, 1991).

The network analyzer 118 has data available to it regarding the signal input to the input terminal 116 of the distributed constant network 111 and regarding the electromagnetic waves received at each observation point $(x,y)$ on the observation plane and. thus, can determine transfer functions between the input terminal 116 and each observation point (x,y). A measurement control unit 133 controls the measurement position (x,y) on the observation plane and the measurement frequency $f_i$ so as to ensure that data is obtained in respect of a plurality of observation points (x,y) at a plurality of observation frequencies $f_l$ to $f_m$ (i.e. i = 1 to m). Measurement control unit 133 controls the storing of the sets of measured transfer functions $H(x,y,f_l)$ to $H(x,y,f_m)$ in data memories $134_l$ to $134_m$.

The set of transfer function data $H(x,y,f_i)$ for each observation frequency $f_i$ is taken out of the respective data memory $134_i$ and is subjected to hologram reconstruction calculations in a hologram reconstruction calculation unit 135. As a result, the two-dimensional radiation pattern on the network 111 is reconstructed from the two-dimensional radiation pattern received on the observation plane 131. That is, transfer function data relating to points (X,Y) in the distributed constant network 111 are extracted from the signals (resulting from interference between electromagnetic waves produced by different portions of the distributed constant network and propagating in space) measured in the observation plane

Let L be the distance between the observation plane 131 and the distributed constant network under observation, D be the dimension of the observation plane 131 and $\lambda_i$ be the observation wavelength. When $L < D^2/\lambda_i$, transfer functions $I(X,Y,f_i)$ for points (X,Y) in the distributed constant network 131 are obtained by performing an inverse-Fresnel transform to the transfer functions $H(x,y,f_i)$, as in the following equation:

$$I(X,Y,f_i) = K \int \int H(\xi,\eta,f_i) \exp\{j\pi/\lambda_i L((\xi-x)^2 + (\eta-y)^2\} \, d\xi \, d\eta \qquad (1),$$

where $K = -j\lambda_i L \exp (j2\pi L/\lambda_i)$, $\lambda_i = c/f_i$, c is the speed of light, $\xi$ is a variable range of x and $\eta$ is a variable range of y. Actually, the Fourier transform (here shown by F) and the inverse-Fourier transform (here shown by $F^{-1}$) are used according to the following equations:

$$I(X,Y,f_i) = F^{-1} [F [H(x,y,f_i)] F[P(x,y,f_i)]] \qquad (2),$$

where $P(x,y,f_i) = \exp(-j\pi(x^2+y^2)/\lambda_i L)$.

When $L>D^2/\lambda_i$, transfer functions $I(u,v,f_i)$ are obtained for the points in the distributed constant network 131, (u being an elevation angle and v being an azimuth angle defining the position of the points in the distributed constant network as seen from the observation plane), by performing a Fourier transform on the transfer functions $H(x,y,f_i)$ according to the following equation:

$$I(u,v,f_i) = \int \int H(x,y,f_i) \exp\{-j2\pi(ux+vy)\} \, dx \, dy \qquad (3).$$

The results of the hologram reconstruction calculations performed by the hologram reconstruction calculation unit 135, for example the results $I(X,Y,f_l)$ to $I(X,Y,f_m)$ produced by an inverse-Fresnel transform, are stored in image memories $136_l$ to $136_m$. A display control unit 137 can specify a point $(X_n,Y_n)$ in the distributed constant network 111 as a point in respect of which data is to be displayed. Corresponding reconstructed output data $I(X_n,Y_n,f_l)$ to $I(X_n,Y_n, f_m)$ is read out from memories $136_l$ to $136_m$ and supplied to a frequency characteristic corrector 138. The frequency characteristic corrector 138 is also supplied, by the display control. unit 137, with frequency characteristic compensation data corresponding to the expected frequency characteristic of an electromagnetic wave leaking from point $(X_n,Y_n)$ of the distributed constant network 111 (taking into account known parameters, for example, the width and thickness of the microstrip line, etc.). The frequency characteristic corrector 138 determines the value of a correction factor needed to compensate for the frequency characteristic indicated by the display control unit 137 and to compensate for frequency characteristics of the observation system (e.g. scanning-antenna receiving means) and multiplies the transfer function data by this correction factor. The corrected data $I'(X_n,Y_n,f_l)$ to $I'(X_n,Y_n,f_m)$ is displayed on a display unit 139.

Furthermore, in this apparatus an inverse-Fourier transform is performed on the output of the frequency characteristic corrector 138 by an inverse Fourier transform unit 141. The transformed data G(X,Y,t) is displayed on a further display unit 142 as a signal waveform. The physical shape of the distributed constant network 111 is displayed on a still further display 143. Display control unit 137 can specify a desired point $(X_n,Y_n)$ in the distributed constant network 111 to be indicated on the image displayed by display unit 143, for example by commanding the display of a cursor at the appropriate location on the display unit 143. Any data $I(X,Y,f_i)$ in the data memories $136_l$ to $136_m$, or data $I'(X,Y,f_i)$ output by the frequency characteristic corrector 138, may be displayed on the display unit 143 either in parallel with, or overlaid on, the representation of the distributed constant network 111.

The video data for generating the displayed image of the physical shape of the distributed constant network 111 may be based on numerical data representing the shape of the network written on a sheet, on computer generated data, etc. In the latter case, the data may be generated by a CAD system which is used for design of the network 111 and may be stored in a memory associated with the display unit 143. Furthermore, the shape of the network 111 may be represented on a transparent sheet or film and laid over a display on which the above-mentioned data $I(X,Y,f_i)$, $I'(X,Y,f_i)$ is to be displayed.

If it is desired to know the transfer function only at one location, or a small selection of locations, on the network 111, then it is not necessary to perform hologram reconstruction calculations for all points in the network 111, that is, hologram reconstruction calculations can be performed only for that or those desired location(s) $(X,Y)$ or $(u,v)$. If the frequency characteristic of the observation system and the radiation frequency characteristic of the network 111 are comparatively smooth within the range of the observation frequency then frequency characteristic corrector 138 can be omitted. Moreover, the display units 139, 142, 143 may be unified into a single display unit displaying data in parallel or switched fashion.

Apparatus according to Fig.1 provides advantages as explained hereafter. First of all, the transfer function is calculated between the input terminal of the network under observation and each observation point $(x,y)$ on an observation plane and then hologram reconstruction calculations are performed to convert these measurement results to reconstructed output values for points in the network 111. Therefore, an accurate value for the transfer function between the input terminal and any chosen point of the network under observation can be found, in a non-contact manner. Moreover, this apparatus avoids the problems of signal loss associated with use of a signal splitter and test terminal, and avoids the problem of complication of network design associated with incorporation of a signal splitter into an integrated unit with other elements of the network.

In the apparatus according to Fig.1, the results of the hologram reconstruction calculations are displayed in two-dimensions together with the shape of the network. Such a display readily enables an abnormal location to be seen, such as a location where, because of soldering, abnormal radiation is being generated. Furthermore, this display makes it simple to specify, by referring to the displayed shape, a location in the network for which data is desired to be known (e.g. using a touch-screen display, or by using manual control of a cursor position, etc.).

In the apparatus according to Fig. 1, transfer functions can be accurately measured, without being distorted by the frequency characteristics of the network 111 or the observation system, by virtue of the use of the frequency characteristic corrector 138.

When the network 111 is incorporated into comparatively large equipment, transfer functions can similarly be measured by non-contact by using the Fourier transform for hologram reconstruction calculations.

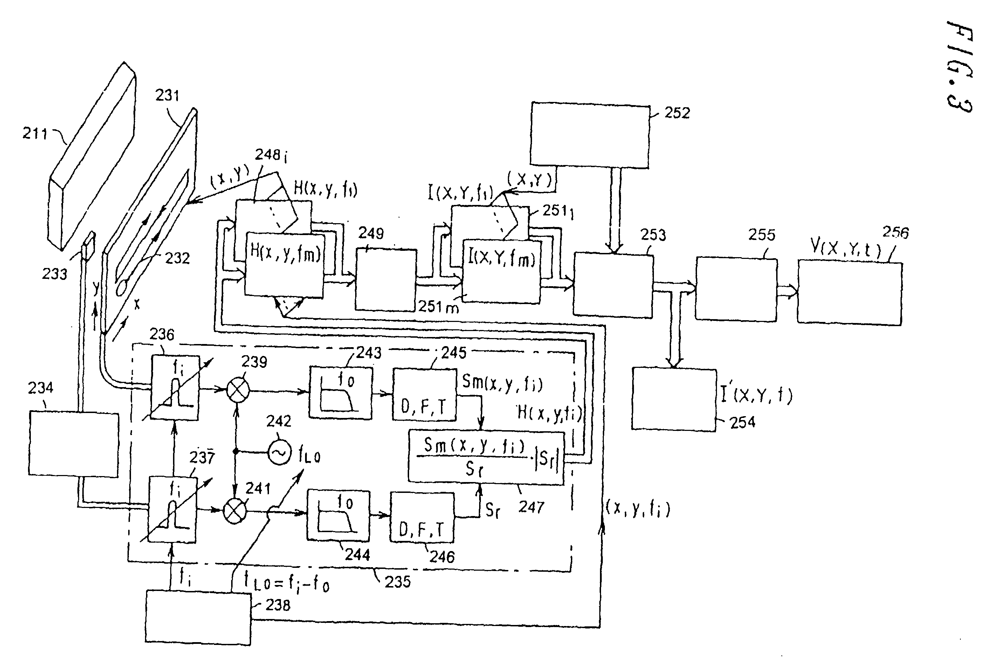

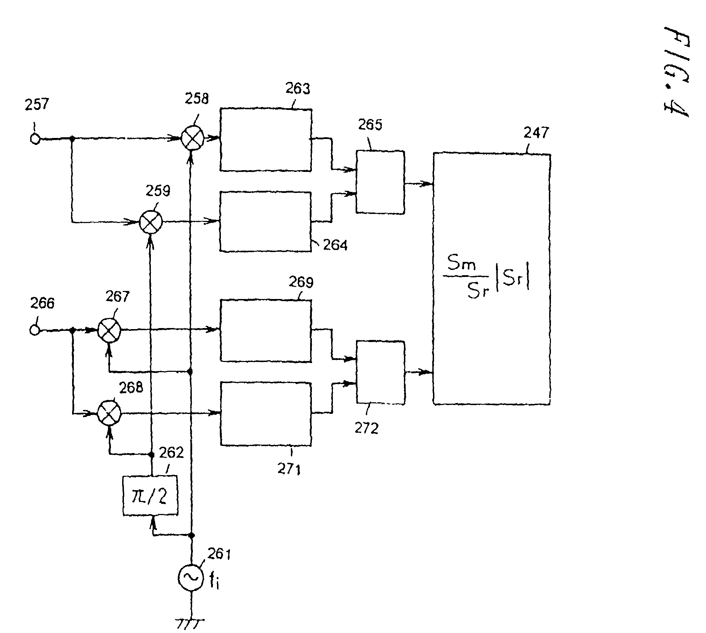

The present invention is explained below referring to Figs.3 and 4.

A preferred embodiment of non-contact type wave signal observation apparatus according to the present invention is shown in Fig.3. Electromagnetic wave observation plane 231 is set up in the vicinity of distributed constant network 211 under observation. Scanning-antenna receiving means is installed in the observation plane 231 to output voltages corresponding to electromagnetic signals received at a plurality of observation points on the observation plane 231. That is, antennas 232, such as monopole antennas or loop antennas, are moved to each observation point $(x,y)$ - defined on an orthogonal co-ordinate system - of the observation plane and a voltage corresponding to the received signal is output. Alternatively, two or more antennas are installed at each observation point of the observation plane 231 so as to form an array antenna. When selected, the elements of the array antenna output a voltage corresponding to the received signal. Preferably, the or each antenna comprises a pair of antennas, for example a dipole antenna and loop antenna, arranged orthogonally and set up to examine the polarization of the received electromagnetic wave. The observation plane 231 is positioned faced a small distance from the distributed constant network under observation.

A pulsed signal is given out by the distributed constant network 211 under observation. Thus, in the embodiment shown in Fig.3, an extra antenna 233 is provided in order to sense the pulsed signal and to enable a reference signal to be generated indicating the timing of the pulsed signal. The output of this antenna 233 is fed to a pulse generation circuit 234 which generates a reference pulse signal synchronised with the operation cycle of the pulsed signal detected by the antenna 233 (i.e. synchronized with the waveform cycle of the network 211). This reference pulse signal should be as sharp as possible (impulse signal), should possess sufficient spectrum density within the range of observation frequencies which it is desired to use and should have a substantially uniform frequency spectrum (that is, spectral lines of similar amplitude). An electromagnetic wave leaks from network 211, albeit usually to a small extent, and this wave is detected by the scanning-antenna receiving means 232, 233 in the observation plane.

A complex voltage conversion circuit 235 converts each voltage output by the scanning-wave receiving antenna 232, 233 in respect of each particular observation point $(x,y)$ at a given observation frequency $f_i$ into a complex voltage based upon the phase of the reference pulse signal generated by the pulse generation circuit 234. In particular, the receive output of the antenna 232 and the reference pulse signal are respectively fed to variable pass band filters 236, 237 whose centre frequencies $f_i$ are set, by a control unit 238, so as to pass (select) the same observation frequency, $f_i$. Control unit 238 also designates the location of the observation point $(x,y)$ at which an observation is to be made at any given time. The frequency components selected by band pass filters 236, 237 are converted to respective low frequency signals by mixing in respective mixers 239, 241 with a local signal of frequency $f_{LO}$ from a local oscillator 242 and subsequent low pass filtering by respective low pass filters 243, 244 each having a cut-off frequency $f_0$ (=$f_i$ - $f_{LO}$).

Discrete Fourier transforms with frequency $f_0$ are performed on the respective outputs of the low pass filters 243, 244 by the discrete Fourier transform units 245, 246. An interferometer 247 performs an interference operation between the spectrum $Sm(X,Y,f_i)$ output by the discrete Fourier transform unit 245 and the output Sr from the discrete Fourier transform unit 246. More particularly, the discrete Fourier transform output $Sm(X,Y,f_i)$ which corresponds to the signal received at observation point (x,y) on the observation plane is converted into $H(x,y,f_i)$ based on the phase of the discrete Fourier transform output Sr corresponding to the pulsed signal, according to the following equation

$$H(x,y,f_i) = \{Sm(X,Y,f_i)/Sr\} \cdot |Sr| \qquad (4)$$

(The interferometer 247 can omit the multiplication by |Sr| where the amplitude of each component of the Fourier transformed signal is the same.) In this manner, the interferometer 247 produces standardized observation data $H(x, y,f_i)$ for each observation point (x,y) at a specified observation frequency $f_i$. This standardized observation data is stored in data memories $248_i$.

The observation frequency is changed through a number of values from $f_l$ to $f_m$ and respective standardized observation data $H(x,y,f_l)$ to $H(x,y,f_m)$ is obtained and stored in respective data memories $248_l$ to $248_m$. When the control unit 238 specifies that a measurement is to be made at a position (x,y) on the observation plane 231, it also specifies the address in data memories $248_l$ to $248_m$ where the corresponding standardized data $H(x,y,f_i)$ is to be stored.

Data stored in the data memories $248_l$ to $248_m$ in respect of a given observation frequency $f_i$ is read out and subjected to an inverse Fresnel transform performed by an inverse Fresnel transform unit 249 according to the above equations (1) and (2). The resultant standardized observation data $I(X,Y,F_l)$ to $I(X,Y,F_m)$ is stored in respective image data memories $251_l$ to $251_m$. In this manner, two dimensions of electromagnetic waves viewed in the observation plane are converted into the frame of reference of the distributed constant network 211. That is, hologram reconstruction calculations are performed on the interference pattern data observed at the observation plane 231, caused by interference between electromagnetic waves radiated from the network 211 by space propagation, and data relating to a chosen point on the network 211 is thus extracted.

When a display control unit 252 specifies a location $(X_n,Y_n)$ in the network 211 under observation, inverse-Fresnel transform data $I(X_n,Y_n,f_l)$ to $I(X_n,Y_n,f_m)$ in respect of that location $(X_n,Y_n)$ is read out from the respective image memories $251_l$ to $251_m$, and supplied to a frequency characteristic corrector 253. The frequency characteristic corrector 253 is supplied, by the display control unit 252, with frequency characteristic compensation data corresponding to the expected frequency characteristic of an electromagnetic wave leaking from point $(X_n,Y_n)$ of the distributed constant network 211 (taking into account known parameters, for example, the width and thickness of the microstrip line, etc.). As in the apparatus shown in Fig. 1, the frequency characteristic corrector 253 may also compensate for the frequency characteristics of the observation system (scanning-antenna receiving means 232 etc.). Even though the inverse-Fresnel transform of a single block of data generates the desired data relating to a specified measurement point (X, Y) on the network 211, it is still necessary to calculate the standardized observation data relating to all the observation positions on the observation plane at each observation frequency.

The distance L between the network 211 and the observation plane 231 is usually arranged to be small since the electromagnetic wave radiated by the network 211 is usually very weak. However, when the network 211 under observation forms part of a comparatively large apparatus then it is likely that $L<D^2/\lambda_i$ (D being the dimension of the observation plane) such that the distance L increases. In such a case, a Fourier transform is performed in place of the above-described inverse-Fresnel transform, that is, calculations are performed according to equation (3) above.

Furthermore, in this embodiment an inverse-Fourier transform is performed on the output of the frequency characteristic corrector 253 by an inverse Fourier transform unit 255. The transformed data V(X,Y,t) is displayed on a further display unit 256 as a signal waveform.

Fig.4 shows another technique by which the standardized observation data $H(x,y,f_i)$ may be obtained. The received signal output by the antenna 232 is supplied. via an input terminal 257, to two multipliers 258 and 259 where it is multiplied respectively by a signal of frequency $f_i$ output by a local oscillator 261, and by a phase-shifted output from the local oscillator 261 (i.e. the output signal from the local oscillator 261 shifted in phase by $\pi/2$ by a phase-shifter 262). The outputs from the multipliers 258, 259 are fed, via respective low pass filters 263,264 having cut-off frequency $f_0$, to a complex Fourier transform unit 265 where they are subjected to a complex Fourier transform to produce a signal $Sm(X,Y,f_i)$. The reference pulse signal from the pulse generation circuit 234 is supplied, via an input terminal 266, to two multipliers 267 and 268 where it is multiplied respectively by the signal of frequency $f_i$ output by local oscillator 261, and the phase-shifted output from the local oscillator 261. The outputs from the multipliers 267, 268 are fed, via respective low pass filters 269, 271 having cut-off frequency $f_0$, to a complex Fourier transform unit 272 where they are subjected to a complex Fourier transform to produce a signal Sr. The signals $Sm(X,Y,f_i)$ and Sr are fed to an interferometer 247 which operates as in the embodiment of Fig.3. The oscillation frequency of the local oscillator 261 is changed within the range of ($f_i$-$f_0$ to $f_i$+$f_0$) and the measurements are repeated for each observation frequency in the range.

As in the apparatus of Fig.1, the frequency characteristic corrector 253 can be omitted when the above-mentioned radiation frequency characteristic and the frequency characteristic of the observation system are comparatively smooth within the range of the observation frequency. Moreover, when the phase becomes substantially complete (by virtue of the amplitude being substantially constant within the range of the observation frequency), interferometer 247 can omit the multiplication by |Sr|. In addition, a single array antenna can be used as the antenna 233 for obtaining the reference timing signal and the antenna 232 for making observations. Moreover, antenna 233 for obtaining the reference timing signal can be omitted entirely, in which case the received signal output by the antenna 232 is supplied to the pulse generation circuit 234. The observation frequency is varied and the observation point (x,y) varied so as to obtain data H(x,y,$f_l$) to H(x,y,$f_m$) for all observation points (x,y) on the observation plane 231.

The present invention provides advantages as explained hereafter. The small amount of electromagnetic radiation radiated by a distributed constant network 211 is received at a plurality of points on an observation plane 231. The repetitive signal emitted by the network 211 is converted into a complex signal taking into account the phase of the repetition at the instant of measurement. In addition, the complex converted received signal is subjected to hologram reconstruction calculations which convert it to a two-dimensional signal in the frame of reference of the network 211 under observation. Therefore the spectrum and signal waveform at a desired point in the network 211 can be correctly measured without influencing the network 211. Moreover, this measurement technique does not induce signal losses in the network 211.

Furthermore, using the apparatus according to the present invention a location in network 211 where abnormal radiation is being caused by solder can readily be found. In embodiments which incorporate a frequency characteristic corrector 253, the signal of a desired point in the network under observation can be measured without distortion by the radiation characteristic of the network 211 or the frequency characteristic of the observation system.

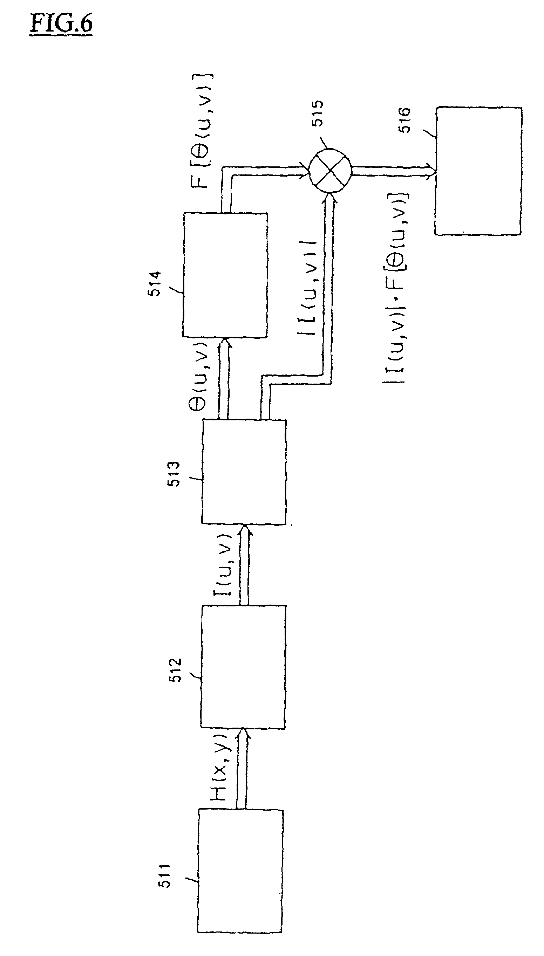

Fig.6 shows a preferred embodiment of display apparatus for complex wave information which may be used to display the data obtained by the non-contact type wave signal observation apparatus of the present invention. Two-dimensional interference data H(x,y) regarding electromagnetic waves in three-dimensional space is obtained from interference data observation means 511. In this example, positions (x,y) in the observation plane are designated using an orthogonal co-ordinate system. A hologram reconstruction unit 512 performs hologram reconstruction calculations using the two-dimensional interference data H(x,y). The Fraunhofer transform is used in the hologram reconstruction calculations, according to the following equation:

$$I(u,v) = \int \int H(x,y) \exp\{-2j\pi \ (ux+vy)\} \ dx \ dy \qquad (5),$$

where u and v are the azimuth angle and the elevation angle, respectively, when viewed from point (x,y) on the observation plane. For instance, at observation points (x,y) on the observation plane spaced apart from the electromagnetic wave source by a distance Z, two-dimensional interference data H(x,y) are observed which represent the data from the source subjected to the transfer function of $\exp\{(j\pi/\lambda Z)(x^2+y^2)\}$. If hologram reconstruction calculations are performed on this two-dimensional interference data H(x,y) the above propagation function becomes $j\lambda Z \ \exp\{-j\pi\lambda Z (u^2+v^2)\}$. In addition, the Fourier integral of the observation plane is convolved into this.

A co-ordinate converter 513 converts the result of such hologram reconstruction calculations from orthogonal co-ordinates to polar co-ordinates I(u,v). That is, the real part and the imaginary part of I(u,v) are calculated. The amplitude and the phase of I(u,v) which correspond to these real and imaginary parts are also calculated. A hue converter 514 converts the phase information θ(u,v) of the co-ordinate-converted data into a colour signal F[θ(u,v)] of a corresponding hue. A multiplication unit 515 modulates the colour signal F[θ(u,v)] by multiplying it by the amplitude information |I(u,v)| of the coordinate-converted data from co-ordinate converter 513. The modulated output |I(u,v)| •F [θ(u,v)] is displayed on a colour display unit 516 as a colour image in the plane of u and v.

For an electromagnetic wave source which is close to the observation plane, the observed amplitude information |I(u,v)| of I(u,v) is large and drops off rapidly towards the periphery of the image corresponding to the source and the observed phase information θ(u,v) changes comparatively slowly while going from the center to the surrounding of the image corresponding to the source. On the other hand, for an electromagnetic wave source which is further away from the observation plane, the observed amplitude information of I(u,v) is small and weakens comparatively slowly while going from the center to the periphery of the image corresponding to the source and the observed phase information changes comparatively rapidly while going from the center to the surrounding of the image corresponding to the source.

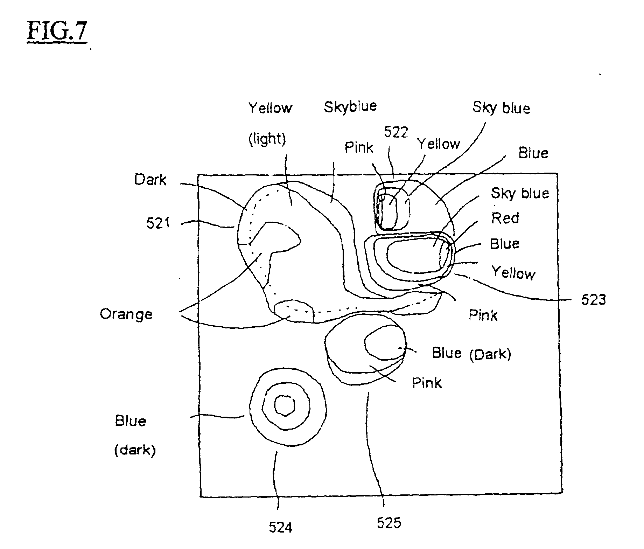

Fig.7 is an example of an image displayed on the display unit 516 when waste/leakage radiation from a piece of electronic equipment is observed at the observation plane by the apparatus of the invention, complex two-dimensional electromagnetic wave interference data is obtained and processing is performed as in the case of Fig.6. The large image 521 on the left upper part of the display is bright, with the brightness reducing rapidly towards the periphery of the image, and the stripes of colour in the image are wide meaning that the observed phase information changes comparatively slowly while going from the center to the surrounding of the image. Therefore, it is understood that image 521 is near the observation plane. Moreover, the colour stripes look wider on the left-hand side than on the right-hand side of image 521 and so an electromagnetic wave of this waste radiation is judged to radiate from the left as seen in the figures.

Image 522, to the right and slightly above image 521 on the image display, is smaller than image 521, has weak brightness and the colour striping is detailed. That is, the phase changes rapidly from the center of the image towards the edges and the striping at the right of the image is coarser than that at the left. That is, it is deduced that image 522 corresponds to a radiation source which is further away and to the right of that corresponding to image 521.

Image 523, between the lower right-hand portion of image 521 and image 522, is slightly larger and brighter than image 522 and the thickness of the colour stripe is about the same as for image 522. Therefore, the radiation source of image 521 is judged to be located at about the same distance as image 522 from the observation plane. However, image 523 corresponds to a slightly stronger source and, from the colour striping, it is understood that this source is radiating to the left because the colour stripes on the right-hand side are finer than those on the left-hand side.

Image 524 spaced apart from image 521 has light and dark portions, the maxilla of the colour stripes are only just fatter than that of the image 522. Therefore, it is judged to correspond to a weak radiation source at a distance which is the same or more than that of the images 522, 523 from the observation plane in the direction perpendicular to the observation plane.

Similarly, image 525, between image 521 and image 524, is judged to correspond to a weak radiation source, radiating to the left, which is comparatively near the observation plane.

With this display, complex two-dimensional wave interference data can be displayed in a manner giving a feeling of distance in a direction at a right angle to the observation plane by converting the phase information into a hue signal and modulating the hue signal by amplitude information. That is, complex three-dimensional space can be displayed using two-dimensional computer graphics.

It is to be understood that the spectra, waveform data, polarisation information, etc. calculated by apparatus according to the invention can be outputted in some manner other than image display discussed above. Thus, for example, the data can be output to a printer for printing in any desired form including, but not limited to, an image representation, numerical data, a graph or chart, etc.; to a memory device; to a further data processing device; etc.

### Claims

1. A non-contact type signal observation apparatus which observes signals at a number of observation points on an electromagnetic wave observation plane (231) set up for a distributed constant network (211) under observation, comprising:

   scanning-antenna receiving means (232) for receiving electromagnetic waves radiated from said network at said observation points and outputting signals as received voltages;
   repetition signal receiving means (233) for receiving a repetition signal from said network;
   means (234) for generating a pulse signal synchronized with said repetition signal;
   complex voltage converting means (235) for converting said received voltages to complex voltages based on the phase of said pulse signal at each observation frequency;
   means (249) for converting said complex voltages to image data using the inverse-Fresnel transform or the Fourier transform; and
   display means (254) for displaying image data as spectra or waveforms.

2. A non-contact type signal observation apparatus according to claim 1 which further comprises characteristic compensating means (253) which, in use, compensates the characteristic of said image data using data of the radiation frequency characteristic of radiation points of said network and the frequency characteristic of said observation apparatus.

3. A non-contact type signal observation apparatus according to claims 1 or 2 wherein said complex voltage converting means (235) is composed of means (236,237) for filtering a frequency component of said observation frequency from both said received voltages and said pulse signal, means (239-244) for converting both filtered signals to low frequency signals, and means (247) for converting transformed results of said received voltages to signals which are referred to the phase of transformed results of said pulse signal.

**4.** A non-contact type signal observation apparatus according to claims 1 or 2 wherein said complex voltage converting means is composed of means (258-264) for converting said received voltages to low frequency signals by a local signal and a quadrature local signal which is phase-shifted by 90 degrees, means (265) for converting said low frequency signals using the complex Fourier transform, means (267-271) for converting said pulse signals to low frequency signal, means (272) for converting said low frequency signals using the discrete Fourier transform, and means (247) for converting transformed results of said received voltages to signals which are referred to the phase of transformed results of said pulse signal.

**5.** A non-contact type signal observation apparatus according to claims 1 to 4 wherein said scanning-antenna receiving means is composed of an array antenna on said observation plane, and received signals of said array antenna are scanned then output.

**6.** A non-contact type signal observation apparatus according to claims 1 to 4 wherein said scanning-antenna receiving means is composed of a scanning antenna (232) which is scanned to specified positions on said observation plane, and received signals of said scanning antenna are output at specified positions.

**7.** A non-contact type signal observation apparatus according to claims 4 or 6 wherein said repetition signal receiving means (233) is composed of a reference timing antenna which receives electromagnetic waves from said network.

**8.** A non-contact type signal observation apparatus according to claim 5 wherein said repetition signal receiving means is composed of a specific element of said array antenna.

**Patentansprüche**

**1.** Kontaktlose Signalbeobachtungsvorrichtung, die Signale an mehreren Beobachtungspunkten einer Beobachtungsebene (231) für elektromagnetische Wellen beobachtet, die für ein beobachtetes, konstantes Verteilnetz (211) aufgebaut ist, mit:

- einer Abtastantennenempfangseinrichtung (232), die vom Netz an den Beobachtungspunkten ausgestrahlte elektromagnetische Wellen empfängt und Signale als empfangene Spannungen ausgibt;
- Wiederholungssignalempfangseinrichtungen (233) für den Empfang eines Wiederholungssignals vom Netz;
- Mittel (234) zur Erzeugung eines Impulssignals, das mit dem Wiederholungssignal synchronisiert ist;
- Einrichtungen (235) zur Umwandlung in komplexe Spannungen zur Umwandlung der empfangenen Spannungen in komplexe Spannungen auf der Basis des Impulssignals bei jeder Beobachtungsfrequenz;
- Mittel (249) zur Umwandlung der komplexen Spannungen in Bilddaten unter Verwendung der inversen Fresnel-Transformation oder der Fourier-Transformation; und
- Anzeigeeinrichtungen (254) zur Anzeige von Bilddaten als Spektren oder Wellenformen.

**2.** Kontaktlose Signalbeobachtungsvorrichtung nach Anspruch 1, die weiter eine Kennlinienkompensationseinrichtung (253) aufweist, die im Betrieb die Kennlinie der Bilddaten unter Verwendung von Daten der Strahlungsfrequenzkennlinie von Strahlungspunkten des Netzes und der Frequenzkennlinie der Beobachtungsvorrichtung kompensiert.

**3.** Kontaktlose Signalbeobachtungsvorrichtung nach Anspruch 1 oder 2, bei der die Einrichtung (235) zur Umwandlung in komplexe Spannungen aus Mitteln (236, 237) zum Filtern einer Frequenzkomponente der Beobachtungsfrequenz sowohl von den empfangenen Spannungen als auch vom Impulssignal, Mitteln (239-244) zur Umwandlung der beiden gefilterten Signale in Niederfrequenzsignale und Mitteln (247) zur Umwandlung der transformierten Ergebnisse der empfangenen Spannungen in Signale besteht, die auf die Phase der transformierten Ergebnisse des Impulssignals bezogen werden.

**4.** Kontaktlose Signalbeobachtungsvorrichtung nach Anspruch 1 oder 2, bei der die Einrichtung zur Umwandlung in komplexe Spannungen aus Mitteln (258-264) zur Umwandlung der empfangenen Spannungen in Niederfrequenzsignale durch ein lokales Signal und ein lokales Quadratur-Signal, das um 90° phasenverschoben ist, Mitteln (265) zur Umwandlung der Niederfrequenzsignale unter Verwendung der komplexen Fourier-Transformation, Mitteln (267-271) zur Umwandlung der Impulssignale in Niederfrequenzsignale, Mitteln (272) zur Umwandlung der Niederfrequenzsignale unter Verwendung der diskreten Fourier-Transformation, und Mitteln (247) zur Umwandlung der transformierten Ergebnisse der empfangenen Spannungen in Signale besteht, die auf die Phase der transformierten Ergebnisse des Impulssignals bezogen werden.

5. Kontaktlose Signalbeobachtungsvorrichtung nach den Ansprüchen 1 bis 4, bei der die Abtastantennenempfangseinrichtung aus einer Array-Antenne in der Beobachtungsebene besteht und die empfangenen Signale der Array-Antenne abgetastet und dann ausgegeben werden.

6. Kontaktlose Signalbeobachtungsvorrichtung nach den Ansprüchen 1 bis 4, bei der die Abtastantennenempfangseinrichtung aus einer Abtastantenne (232) besteht, die auf bestimmte Positionen in der Beobachtungsebene bewegt wird, und die empfangenen Signale der Abtastantenne an bestimmten Positionen ausgegeben werden.

7. Kontaktlose Signalbeobachtungsvorrichtung nach den Ansprüchen 4 oder 6, bei der die Wiederholungssignalempfangseinrichtung (233) aus einer Bezugstaktantenne besteht, die elektromagnetische Wellen vom Netz empfängt.

8. Kontaktlose Signalbeobachtungsvorrichtung nach Anspruch 5, bei der die Wiederholungssignalempfangseinrichtung aus einem spezifischen Element der Array-Antenne besteht.

**Revendications**

1. Dispositif d'observation de signal du type sans contact qui observe des signaux en un certain nombre de points d'observation sur un plan d'observation d'ondes électromagnétiques (231) établi pour un réseau à constantes réparties (211) sous observation, comprenant :

   un moyen de réception à antenne de balayage (232) destiné à recevoir des ondes électromagnétiques rayonnées à partir dudit réseau auxdits points d'observation et à fournir en sortie des signaux sous forme de tensions reçues,
   un moyen de réception de signal de répétition (233) destiné à recevoir un signal de répétition provenant dudit réseau,
   un moyen (234) destiné à générer un signal d'impulsion synchronisé avec ledit signal de répétition,
   un moyen de conversion de tensions complexes (235) destiné à convertir lesdites tensions reçues en des tensions complexes sur la base de la phase dudit signal d'impulsion à chaque fréquence d'observation,
   un moyen (249) destiné à convertir lesdites tensions complexes en des données d'image en utilisant la transformation de Fresnel inverse ou la transformation de Fourier, et
   un moyen d'affichage (254) destiné à afficher des données d'image sous forme de spectres ou de formes d'ondes.

2. Dispositif d'observation de signal du type sans contact selon la revendication 1, qui comprend en outre un moyen de compensation de caractéristiques (253) qui, en utilisation, compense une caractéristique desdites données d'image en utilisant des données de caractéristiques de fréquence de rayonnement des points de rayonnement dudit réseau et des caractéristiques en fréquence dudit dispositif d'observation.

3. Dispositif d'observation de signal du type sans contact selon les revendications 1 ou 2, dans lequel ledit moyen de conversion de tensions complexes (235) est composé d'un moyen (236, 237) destiné à filtrer une composante de fréquence de ladite fréquence d'observation à partir à la fois desdites tensions reçues et dudit signal d'impulsion, un moyen (239 à 244) destiné à convertir en même temps des signaux filtrés en des signaux à basse fréquence, et un moyen (247) destiné à convertir les résultats transformés desdites tensions reçues en des signaux qui sont référencés par rapport à la phase des résultats transformés dudit signal d'impulsion.

4. Dispositif d'observation de signal du type sans contact selon les revendications 1 ou 2, dans lequel ledit moyen de conversion de tension complexe est composé d'un moyen (258 à 264) destiné à convertir lesdites tensions reçues en des signaux à basse fréquence grâce à un signal local et un signal local en quadrature qui est déphasé de 90 degrés, un moyen (265) destiné à convertir lesdits signaux à basse fréquence en utilisant la transformation de Fourier complexe, un moyen (267 à 271) destiné à convertir ledit signal d'impulsion en un signal à basse fréquence, un moyen (272) destiné à convertir lesdits signaux à basse fréquence en utilisant la transformation de Fourier discrète, et un moyen (247) destiné à convertir les résultats transformés desdites tensions reçues en des signaux qui sont référencés par rapport à la phase des résultats transformés dudit signal d'impulsion.

5. Dispositif d'observation de signal du type sans contact selon les revendications 1 à 4, dans lequel ledit moyen de réception à antenne à balayage est composé d'une antenne en réseau sur ledit plan d'observation, et lesdits signaux reçus de ladite antenne en réseau sont balayés lorsqu'ils sont fournis en sortie.

6. Dispositif d'observation de signal du type sans contact selon les revendications 1 à 4, dans lequel ledit moyen de réception à antenne à balayage est composé d'une antenne à balayage (232) qui est balayée vers des positions spécifiées sur ledit plan d'observation, et les signaux reçus de ladite antenne à balayage sont fournis en sortie à des emplacements spécifiés.

7. Dispositif d'observation de signal du type sans contact selon les revendications 4 ou 6, dans lequel ledit moyen de réception de signal de répétition (233) est composé d'une antenne de cadencement de référence qui reçoit des ondes électromagnétiques provenant dudit réseau.

8. Dispositif d'observation de signal du type sans contact selon la revendication 5, dans lequel ledit moyen de réception de signal de répétition est composé d'un élément spécifique de ladite antenne en réseau.

# FIG. 1

# FIG.2

FIG.3

EP 0 981 055 B1

*FIG. 4*

FIG.5

## FIG.6

## FIG.7